# EUROPÄISCHE PATENTSCHRIFT

(11) **EP 1 298 711 B1**
(45) Veröffentlichungstag und Bekanntmachung des Hinweises auf die Patenterteilung: **09.02.2011**
(21) Anmeldenummer: 02018590.6
(22) Anmeldetag: 19.08.2002
(51) Int. Cl.: H01L 21/28, H01L 29/788, H01L 29/423

(54) **Verfahren zum Herstellen einer integrierten Halbleiteranordnung**
Manufacturing method of an integrated semiconductor arrangement
Procédé de fabrication d'un dispositif semi-conducteur intégré

(30) Priorität: 01.10.2001 DE 10148491
(43) Veröffentlichungstag der Anmeldung: 02.04.2003
(73) Patentinhaber: Infineon Technologies AG, 85579 Neubiberg (DE)
(72) Erfinder: Hammer, Markus, 93342 Saal a.d. Donau (DE)
(74) Vertreter: Kindermann, Peter

(56) Entgegenhaltungen:
- EP-A- 0 373 698
- JP-A- 9 205 157
- US-A- 5 017 979
- US-A- 5 210 044
- US-A- 5 460 991
- LAI W H ET AL: "Growth characterization of rapid thermal oxides" JOURNAL OF VACUUM SCIENCE & TECHNOLOGY B: MICROELECTRONICS PROCESSING AND PHENOMENA, AMERICAN VACUUM SOCIETY, NEW YORK, NY, US, Bd. 17, Nr. 5, September 1999 (1999-09), Seiten 2226-2238, XP012007722 ISSN: 0734-211X

## Beschreibung

Die Erfindung betrifft unter anderem ein Verfahren, bei dem auf einem Substrat oder auf einer Grundschicht eine Hauptschicht aufgebracht wird, die z.B. amorph oder polykristallin ist. Die Hauptschicht wird beim Aufbringen oder nach dem Aufbringen dotiert. Später wird die Hauptschicht dann strukturiert.

Aus der US 5,460,991 ist ein EEPROM bekannt, der einen ONO-Schichtstapel enthält, welcher in Ofenprozessen erzeugt wird. Aus der US 5,210,044 ist ein EEPROM bekannt, der einen ONO-Schichtstapel enthält.

Aus der Zusammenfassung der JP 09205157 ist ein EEPROM bekannt, bei dem eine untere Polysiliziumschicht mit RTP nitridiert wird, bevor ein Oxidfilm mit RTP erzeugt wird. Auf den Oxidfilm wird direkt eine zweite Polysiliziumschicht abgeschieden. Aus der EP 373 698 ist ein EEPROM mit Löschgate bekannt, das eine Unebenheit enthält. W. H. Lai, u. a., "Growth characterization of rapid thermal oxides", J. Vac. Sci Technol. B 17(5), Sep/Oct 1999, Seite 2226 bis Seite 2238, betrifft allgemeine Experimente für RTP Oxidationen auf einkristallinem Silizium.

Es ist Aufgabe der Erfindung, zum Herstellen einer integrierten Halbleiteranordnung ein Verfahren anzugeben, das insbesondere einfach ist und das insbesondere eine gute Strukturierung der Hauptschicht erlaubt.

Die auf das Verfahren bezogene Aufgabe wird durch die im Patentanspruch 1 angegebenen Verfahrensschritte gelöst. Weiterbildungen sind in den Unteransprüchen angegeben.

Beim erfindungsgemäßen Verfahren wird zusätzlich zu den eingangs genannten Verfahrensschritten vor der Strukturierung der Hauptschicht auf der Hauptschicht durch thermische Oxidation eine Oxidschicht erzeugt. Die thermische Oxidation wird bei Temperaturen größer als 900°C für eine Zeit kleiner als 65 Sekunden ausgeführt, d.h. in einem sogenannten RT-Prozess (Rapid Thermal Processing). Außerdem ist die thermische Oxidation nach dem Abscheiden der Hauptschicht der erste Prozessschritt mit einer Prozesstemperatur, die größer als die Prozesstemperatur beim Abscheiden der Hauptschicht bzw. etwa gleich dieser Prozesstemperatur ist. Nach dem RT-Prozess ist die Hauptschicht auch dann polykristallin, wenn die Hauptschicht zunächst amorph war.

Die Erfindung geht von der Überlegung aus, dass die Kornstruktur der Hauptschicht durch den nächsten der Abscheidung der Hauptschicht folgenden Temperaturschritt im Wesentlichen festgelegt wird. Ist dieser nächste Temperaturschritt ein RT-Prozessschritt, so entsteht eine Kornstruktur, die für die Strukturierung eines polykristallinen Materials sehr günstig ist, insbesondere hinsichtlich der Korngröße und hinsichtlich von glatten Korngrenzen. Gleichzeitig wird beim erfindungsgemäßen Verfahren bei diesem Temperaturschritt eine thermische Oxidation ausgeführt, um auf der Hauptschicht eine Oxidschicht zu erzeugen, die eine Dicke von einigen Nanometern hat.

Wird die polykristalline Schicht nach ihrem Aufbringen dotiert, so wird durch den Temperaturschritt außerdem ein Ausheilen erreicht. Das bedeutet, dass der RT-Prozess dann drei Funktionen hat, nämlich:
- eine günstige Grundkornstruktur zu erzeugen,
- die Oxidation in einer sauerstoffhaltigen Atmosphäre zu bewirken, und
- die Ausheilung zu ermöglichen.

Bei einer Weiterbildung des erfindungsgemäßen Verfahrens wird die auf der Hauptschicht erzeugte Oxidschicht auf der gesamten Hauptschicht aufgebracht. Die Oxidschicht wird vor der Strukturierung der polykristallinen Schicht ebenfalls strukturiert. Durch diese Maßnahme wird erreicht, dass es nicht erforderlich ist, nach dem Aufbringen der Hauptschicht weitere Schichten abzuscheiden und zu strukturieren, um ein nur lokales Aufwachsen der Oxidschicht zu gewährleisten. Die Prozessschritte zum Aufbringen weiterer Schichten würden die Grundstruktur der einkristallinen Körner in der polykristallinen Schicht hinsichtlich der späteren Strukturierung dieser Schicht negativ beeinflussen.

Bei einer anderen Weiterbildung ist die Grundschicht eine von dem Substrat getragene Oxidschicht. Die Grundschicht befindet sich beispielsweise unmittelbar auf der Oberfläche des Substrates. Es lassen sich jedoch auch weitere Schichten zwischen Grundschicht und Substrat anordnen.

Bei einer anderen Weiterbildung des erfindungsgemäßen Verfahrens wird beim Strukturieren das Substrat bereichsweise freigelegt, ohne das Substrat selbst anzugreifen. Alternativ wird beim Strukturieren die Grundschicht bereichsweise freigelegt, ohne die Grundschicht selbst anzugreifen. Eine derart genaue Strukturierung lässt sich beispielsweise mit Hilfe eines Plasmaätzprozesses nur dann durchführen, wenn die polykristalline Schicht für den Ätzprozess geeignete Kristallkörner enthält. Eine geeigneten Grundstruktur der Kristallkörner lässt sich mit Hilfe des erfindungsgemäßen Verfahrens erzielen.

Reste der Hauptschicht in den freigelegten Bereichen bzw. Anätzungen der Grundschicht oder des Substrats in den freigelegten Bereichen lassen sich indirekt über verschlechterte elektronische Eigenschaften von Bauelementen bei Betrachtung einer Vielzahl von Bauelementen nachweisen. Durch den Einsatz der Weiterbildung verbessern sich diese Eigenschaften wenn eine Vielzahl von Bauelementen betrachtet wird, so dass davon ausgegangen werden muss, dass es Reste bzw. Anätzungen nicht mehr oder doch nur in einem für die elektrische Funktion der Bauelemente unerheblichen Ausmaß gibt.

Bei einer anderen Weiterbildung des erfindungsgemäßen Verfahrens wird nach der thermischen Oxidation und vor der Strukturierung auf die Oxidschicht eine dielektrische Schicht aufgebracht. Die dielektrische Schicht wird bei einer Ausgestaltung vor der Strukturierung der polykristallinen Schicht ebenfalls strukturiert. Die dielektrische Schicht ist bei einer Ausgestaltung aus einem Material, das sich von dem Material der Oxidschicht unterscheidet. Es entsteht dadurch ein Stapel elektrisch isolierenden Schichten, der besonders gute Isoliereigenschaften hat.

Bei einer nächsten Weiterbildung ist die dielektrische Schicht eine Nitridschicht, insbesondere eine Siliziumnitridschicht. Eingesetzt werden aber bspw. auch Oxinitridschichten.

Bei einer Weiterbildung des erfindungsgemäßen Verfahrens wird nach dem Aufbringen der dielektrischen Schicht und vor der Strukturierung auf der dielektrischen Schicht eine Oxidschicht abgeschieden. Die Oxidschicht wird bei einer Ausgestaltung vor der Strukturierung der Hauptschicht ebenfalls strukturiert. Durch diese Maßnahme entsteht ein Stapel aus mindestens drei Isolationsschichten, der besonders gute Isolationseigenschaften bei einer möglichst geringen Stapelhöhe hat. Beispielsweise ist der Schichtstapel ein sogenannter ONO-Stapel (Oxid Nitrid Oxid bzw. Oxinitrid Nitrid Oxid). Als Oxidschicht ist u.a. eine Siliziumdioxidschicht geeignet.

Bei dem erfindungsgemäßen Verfahren wird in eine bei der Strukturierung der Hauptschicht erzeugte Vertiefung eine elektrisch leitende Schicht eingebracht. Zumindest ein Teil der elektrisch leitenden Schicht verbleibt in der Vertiefung und wird so Bestandteil eines elektronischen Bauelementes.

Bei dem erfindungsgemäßen Verfahren verbleibt ein Teil der elektrisch leitenden Schicht innerhalb der Vertiefung und ein Teil der elektrisch leitenden Schicht verbleibt außerhalb der Vertiefung. Sind beide Teile elektrisch leitend verbunden, so bilden sie Bestandteile desselben Bauelementes. Insbesondere ist das erfindungsgemäße Verfahren für die Herstellung des Steueranschlusses eines Speichertransistors geeignet. Das erfindungsgemäße Verfahren dient weiterhin insbesondere zur Herstellung von Steueranschlüssen für sogenannte Split-Gate-Speicherzellen. Die einzelnen Speicherzellen haben in dieser Technologie beispielsweise eine Zellgröße von 0,5 µm in Richtung der kleineren Breite. Jedoch lässt sich das erfindungsgemäße Verfahren auch bei kleineren Zellgrößen einsetzen, beispielsweise bei Zellgrößen von 0,35 µm.

Das Substrat ist bei einer Weiterbildung ein Halbleitermaterial mit einem spezifischen elektrischen Widerstand zwischen 10⁻⁴ Ωcm und 10⁺¹² Ωcm, insbesondere ein Siliziumwafer. Die Hauptschicht besteht bei einer nächsten Weiterbildung aus polykristallinem Silizium. Die Grundschicht ist bei einer Weiterbildung eine Oxidschicht, die auf dem Substrat durch thermische Oxidation erzeugt wird. Die genannten Materialien sind für eine einfache Prozessierung besonders geeignet.

Bei einer nächsten Weiterbildung liegt die Zeit für die thermische Oxidation zwischen 3 Sekunden und 35 Sekunden, vorzugsweise bei 5 Sekunden. Eine Zeit von 5 Sekunden ist besonders geeignet, weil die für eine gute Strukturierung der polykristallinen Schicht erforderliche Grundstruktur der Körner bereits erreicht ist und eine Fortführung der thermischen Oxidation zu unerwünscht großen Oxidschichten und gegebenenfalls auch zu Schäden in der polykristallinen Schicht führt.

Bei dem erfindungsgemäßen Verfahren liegt die Temperatur für die thermische Oxidation im Bereich von 1000°C bis 1100°C. Vorzugsweise beträgt die Temperatur 1050°C. Die genannte Temperatur ermöglicht einen kurzen RT-Prozess, ohne die polykristalline Struktur durch hohe Temperaturen zu stark zu schädigen.

Bei dem erfindungsgemäßen Verfahren wird die thermische Oxidation in einer RTP-Anlage (rapid thermal processing) ausgeführt. Beispielsweise wird die Hauptschicht mit Hilfe einer geheizten Graphitplatte oder mit Hilfe einer Hochleistungslampe aufgeheizt. Das Aufheizen ist von einer Seite her oder von beiden Seiten her möglich.

Im Folgenden werden Ausführungsbeispiele der Erfindung an Hand der beiliegenden Zeichnungen erläutert. Darin zeigen:
- Figur 1: einen Querschnitt durch eine Schichtenfolge,
- Figur 2: einen Querschnitt durch einen aus der Schichtenfol- ge erzeugten Speichertransistor, und
- Figur 3: einen Querschnitt durch eine Split-Gate- Speicherzelle.

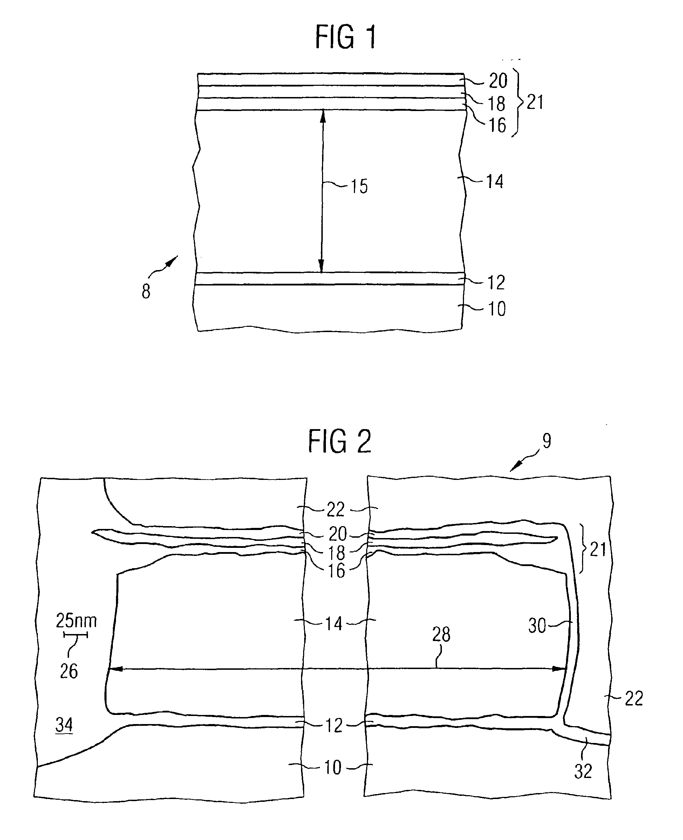

Figur 1 zeigt einen Querschnitt durch eine Schichtenfolge 8, die auf einem Silizium-Halbleiterwafer 10 mit Hilfe der folgenden Verfahrensschritte aufgebracht worden ist:
- durch thermische Oxidation des Halbleiterwafers 10 wurde eine Siliziumdioxidschicht 12 erzeugt, die eine Dicke von wenigen Nanometern hat, z.B. eine Dicke von 7,5 nm.
- Auf der Siliziumdioxidschicht 12 wurde eine polykristalline Schicht 14 mit Hilfe eines Niederdruck-CVD-Verfahrens (Chemical Vapor Deposition) bei etwa 630°C abgeschieden. Als Reaktionsprodukte wurde Silan (SiH4) und Phosphin (PH3) verwendet. Die polykristalline Schicht 14 hat bspw. eine Dicke von etwa 200 nm, siehe Pfeil 15.

Durch den Phosphinanteil wurde die polykristalline Schicht 14 bei ihrer Abscheidung mit Phosphor stark dotiert. Der Phosphorgehalt beträgt beispielsweise 3 x 10²⁰ Atome je cm³.
- Nach dem Erzeugen der polykristallinen Schicht 14 wurde eine schnelle thermische Oxidation bei 1050°C für 5 Sekunden ausgeführt, um auf der polykristallinen Schicht 14 eine dünne Siliziumdioxidschicht 16 zu erzeugen und gleichzeitig die Kornstruktur der polykristallinen Schicht 14 hinsichtlich deren späterer Strukturierung zu verbessern. Die Siliziumdioxidschicht 16 hat beispielsweise eine Dicke von etwa 6 nm.
- Auf der Siliziumdioxidschicht wurde danach mit Hilfe eines CVD-Verfahrens eine dünne Nitridschicht 18 abgeschieden. Die Nitridschicht 18 besteht aus Siliziumnitrid und hat eine Dicke von 5 nm.
- Auf der Nitridschicht 18 wurde anschließend eine dünne Siliziumdioxidschicht 20 mit Hilfe eines CVD-Verfahrens abgeschieden. Die Siliziumdioxidschicht 20 hat beispielsweise eine Dicke von 7 nm.

Die Siliziumdioxidschicht 16, die Nitridschicht 18 und die Siliziumdioxidschicht 20 bilden zusammen einen ONO-Schichtenstapel 21 (Oxid Nitrid Oxid).

Figur 2 zeigt einen Querschnitt durch einen Speichertransistor 9, der bei der weiteren Bearbeitung der Schichtenfolge 8 entsteht. Figur 2 ist die direkte Wiedergabe einer TEM-Aufnahme (Transmission Electron Microscope) des Speichertransistors 9. Somit erklären sich die gewellten Kantenverläufe. Der Speichertransistor 9 enthält eine Steuerelektrode 22, die sowohl oberhalb der polykristallinen Schicht 14 als auch rechts neben der polykristallinen Schicht 14 liegt.

Die Figur 2 ist eine maßstabsgetreue Wiedergabe des Speichertransistors 9. Ein Maßstab 26 zeigt, dass 1 cm in der Figur 2 25 nm des Speichertransistors 9 entspricht. In Figur 2 sind nur die Randbereiche der durch die polykristalline Schicht 14 gebildeten Speicherelektrode des Speichertransistors dargestellt. In lateraler Richtung hat die polykristalline Schicht 14 nach ihrer Strukturierung eine Ausdehnung von etwa 550 nm, siehe Pfeil 28.

Nach den an Hand der Figur 1 erläuterten Verfahrensschritten wurden die folgenden Verfahrensschritte durchgeführt:
- auf den Schichtenstapel 8 wurde eine Fotolackschicht aufgebracht.
- Die Fotolackschicht wurde gemäß einer Belichtungsmaske belichtet.
- Die Fotolackschicht wurde entwickelt, wobei ein Fotolackbereich oberhalb der polykristallinen Schicht 14 verblieben ist.
- Die Schichten 20, 18, 16 und 14 wurden in dieser Reihenfolge mit Hilfe eines Plasmaatzprozesses strukturiert, wobei zum Atzen der Schichten 20, 18, 16 bzw. 14 jeweils geeignete Ätzmittel eingesetzt worden sind. Die letzte Stufe des Ätzprozesses wurde mit einem Ätzmittel ausgeführt, das Polysilizium selektiv zu Siliziumdioxid ätzt, beispielsweise sind die Atzraten mindestens um den Faktor 10 verschieden. Der Atzprozess wurde auf der Oberfläche der Siliziumdioxidschicht 12 gestoppt.
- Anschließend wurde mit Hilfe einer thermischen Oxidation ein Seitenwandoxid 30 an den Seitenwänden der polykristallinen Schicht 14 erzeugt. Bei dieser thermischen Oxidation entstand in den freiliegenden Bereichen der Siliziumdioxidschicht 12 eine Siliziumdioxidschicht 32, die dicker als die Siliziumdioxidschicht 12 ist und später die Steuerelektrode 22 vom Siliziumwafer 10 isoliert.
- Anschließend wurde eine polykristalline Schicht abgeschieden und strukturiert, wobei die Steuerelektrode 22 entstand.
- In einem Bereich 34 wurde weiterhin ein Zwischenoxid abgeschieden.

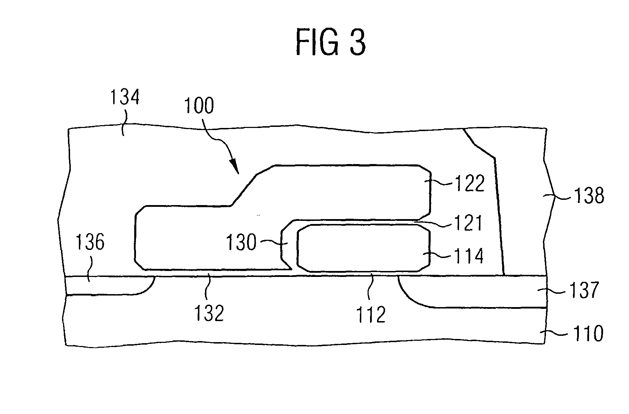

Figur 3 zeigt einen Querschnitt durch eine Split-Gate-Speicherzelle 100, die auf einem Siliziumsubstrat 110 angeordnet ist und die wie die Speicherzelle 9 aufgebaut ist, mit der Ausnahme, dass sich eine Steuerelektrode von dem Bereich oberhalb einer Speicherelektrode 114 zur linken Seite der Speicherelektrode 114 hin erstreckt.

Die Speicherelektrode 114 ist auf einer Siliziumdioxidschicht 112 angeordnet, die als Tunneloxid wirkt. An der der Siliziumdioxidschicht 112 abgewandten Seite der Speicherelektrode 114 befindet sich ein ONO-Schichtenstapel 121, auf dem ein oberer Teil der Steuerelektrode 122 ruht. Zwischen der Seitenwand der Speicherelektrode 114 und der Steuerelektrode 122 befindet sich ein Seitenwandoxid 130.

Zwischen dem näher am Substrat 110 liegendem Teil der Steuerelektrode 122 und dem Substrat 110 liegt eine Siliziumdioxidschicht 132, die als Hochvoltgateoxid für Spannungen bis 16 Volt wirkt. Ein Bereich 134 ist wiederum mit einem isolierenden Zwischenoxid gefüllt.

Die Steuerelektrode 122 und die Speicherelektrode 114 werden von einem dotierten Source-Gebiet 136 und von einem dotierten Drain-Gebiet 137 begrenzt, die in das Substrat 110 eingebracht worden sind. Eine in einem Kontaktloch eingebrachte Metallisierung 138 erstreckt sich bis zum Drain-Gebiet 137.

Bei einem anderen Ausführungsbeispiel wird eine Stapel-Speicherzelle durch Anwendung der gleichen Verfahrensschritte, wie oben erlautert, hergestellt. Bei der Stapel-Speicherzelle befindet sich die Steuerelektrode nur oberhalb der Speicherelektrode. Das Drain-Gebiet bzw. das Source-Gebiet grenzen direkt an die Speicherelektrode an.

Durch die beschriebene Prozessführung wird erreicht, dass das Polysilizium der polykristallinen Schicht bzw. der Speicherelektrode eine Kornstruktur hat, die für die nachfolgende Strukturierung bestens geeignet ist. Beispielsweise entstehen Korngrenzen von Kornern mit einem Durchmesser von etwa 200 nm. Auch die Rauheit an der Oberfläche der Speicherelektrode wird verringert.

### Bezugszeichenliste

- 8: Schichtfolge
- 9: Speichertransistor
- 10, 110: Siliziumwafer
- 12, 112: Siliziumdioxidschicht
- 14, 114: polykristalline Schicht
- 16: Siliziumdioxid
- 18: Nitridschicht
- 20: Siliziumdioxid
- 21, 121: ONO-Schichtstapel
- 22, 122: Steuerelektrode
- 26: Maßstab
- 28: Pfeil
- 30, 130: Seitenwandoxid
- 32, 132: Siliziumdioxidschicht
- 34, 134: Bereich
- 100: Split-Gate-Speicherzelle
- 136: Source-Gebiet
- 137: Drain-Gebiet
- 138: Metallisierung

## Patentansprüche

1. Verfahren zum Herstellen einer integrierten Split-Gate-Halbleiteranordnung (9, 100),
bei dem an einer Fläche eines Substrats (10) oder einer Grundschicht (12) eine Hauptschicht (14) erzeugt wird,
bei dem die Hauptschicht (14) beim Erzeugen oder nach dem Erzeugen dotiert wird,
bei dem an der Hauptschicht (14) durch thermische Oxidation eine Oxidschicht (16) erzeugt wird,
und bei dem die Hauptschicht (14) strukturiert wird,
wobei die thermische Oxidation nach dem Erzeugen der Hauptschicht (14) der erste Prozessschritt mit einer Prozesstemperatur ist, die größer als die oder etwa gleich der Prozesstemperatur beim Erzeugen der Hauptschicht (14) ist,
und wobei die Hauptschicht (14) eine polykristalline Speicherelektroden-Siliziumschicht ist, an der die Oxidschicht (16) erzeugt wird,
**dadurch gekennzeichnet, dass** die thermische Oxidation in einer RTP-Anlage für eine Zeit kleiner als 35 Sekunden bei einer Temperatur von 1000°C bis 1100°C ausgeführt wird,
dass in einer bei der Strukturierung erzeugten Vertiefung eine elektrisch leitende Schicht (22) eingebracht wird,
dass ein Teil der elektrisch leitenden Schicht (22) innerhalb der Vertiefung und ein Teil der elektrisch leitenden Schicht (22) außerhalb der Vertiefung verbleibt, und
dass die beiden Teile den Split-Gate-Anschluss (22) eines Speichertransistors (9, 100) bilden.

2. Verfahren nach Anspruch 1, **dadurch gekennzeichnet, dass** die Oxidschicht (16) auf der gesamten freiliegenden Fläche der Hauptschicht (14) erzeugt wird, und dass die Oxidschicht (16) vor der Strukturierung der Hauptschicht (14) strukturiert wird.

3. Verfahren nach Anspruch 1 oder 2, **dadurch gekennzeichnet, dass** die Grundschicht (12) eine an einer Fläche des Substrats (10) erzeugte Oxidschicht ist.

4. Verfahren nach einem der vorhergehenden Ansprüche, **dadurch gekennzeichnet, dass** beim Strukturieren das Substrat (10) bereichsweise freigelegt wird, ohne das Substrat selbst anzugreifen,
oder dass beim Strukturieren die Grundschicht (12) bereichsweise freigelegt wird, ohne die Grundschicht (12) selbst anzugreifen.

5. Verfahren nach einem der vorhergehenden Ansprüche, **dadurch gekennzeichnet, dass** nach der thermischen Oxidation und vor der Strukturierung eine dielektrische Schicht (18) erzeugt wird,
und/oder dass die dielektrische Schicht (18) vor der Strukturierung der Hauptschicht (14) strukturiert wird.

6. Verfahren nach Anspruch 5, **dadurch gekennzeichnet, dass** die dielektrische Schicht (18) eine Nitridschicht ist,
und/oder dass die dielektrische Schicht (18) eine Siliziumnitridschicht ist,
und/oder dass die dielektrische Schicht (18) eine Oxinitridschicht enthält.

7. Verfahren nach Anspruch 5 oder 6, **dadurch gekennzeichnet, dass** nach dem Erzeugen der dielektrischen Schicht (18) und vor der Strukturierung eine Oxidschicht (20) erzeugt wird,
und/oder dass die Oxidschicht (20) vor der Strukturierung der Hauptschicht (14) ebenfalls strukturiert wird.

8. Verfahren nach Anspruch 7, **dadurch gekennzeichnet, dass** die Oxidschicht (20) eine Siliziumdioxid enthaltende Schicht oder eine Siliziumdioxidschicht ist.

9. Verfahren nach einem der vorhergehenden Ansprüche, **dadurch gekennzeichnet, dass** das Substrat (10, 110) ein Halbleitermaterial ist, insbesondere Silizium, und/oder dass die Grundschicht eine Oxidschicht ist, die auf dem Substrat vorzugsweise durch thermische Oxidation erzeugt worden ist, insbesondere eine Siliziumdioxidschicht.

10. Verfahren nach einem der vorhergehenden Ansprüche, **dadurch gekennzeichnet, dass** die Zeit für die thermische Oxidation größer als 3 Sekunden ist,
und/oder dass die Zeit für die thermische Oxidation 5 Sekunden beträgt.

11. Verfahren nach einem der vorhergehenden Ansprüche, **dadurch gekennzeichnet, dass** die Temperatur für die thermische Oxidation etwa 1050°C beträgt.

## Claims

1. Method for manufacturing an integrated split-gate semiconductor arrangement (9, 100),
wherein a main layer (14) is produced at a surface of a substrate (10) or a base layer (12),
wherein the main layer (14) is doped during production or after production,
wherein an oxide layer (16) is produced at the main layer (14) by thermal oxidation,
and wherein the main layer (14) is patterned,
wherein the thermal oxidation after the production of the main layer (14) is the first process step at a process temperature greater than or approximately equal to the process temperature during the production of the main layer (14),
and wherein the main layer (14) is a polycrystalline memory electrode silicon layer at which the oxide layer (16) is produced,
**characterized in that** the thermal oxidation is performed in an RTP installation for a time of less than 35 seconds at a temperature of 1000°C to 1100°C,
**in that** an electrically conductive layer (22) is introduced in a depression produced during the patterning,
**in that** a part of the electrically conductive layer (22) remains within the depression and a part of the electrically conductive layer (22) remains outside the depression, and
**in that** the two parts form the split-gate terminal (22) of a memory transistor (9, 100).

2. Method according to Claim 1,
**characterized in that** the oxide layer (16) is produced on the entire uncovered surface of the main layer (14), and **in that** the oxide layer (16) is patterned before the patterning of the main layer (14).

3. Method according to Claim 1 or 2,
**characterized in that** the base layer (12) is an oxide layer produced at a surface of the substrate (10).

4. Method according to any of the preceding claims, **characterized in that**, during patterning, the substrate (10) is uncovered in regions without the substrate itself being attacked,
or **in that**, during patterning, the base layer (12) is uncovered in regions without the base layer (12) itself being attacked.

5. Method according to any of the preceding claims, **characterized in that** a dielectric layer (18) is produced after the thermal oxidation and before the patterning,
and/or **in that** the dielectric layer (18) is patterned before the patterning of the main layer (14).

6. Method according to Claim 5, **characterized in that** the dielectric layer (18) is a nitride layer,
and/or **in that** the dielectric layer (18) is a silicon nitride layer,
and/or **in that** the dielectric layer (18) contains an oxynitride layer.

7. Method according to Claim 5 or 6, **characterized in that** an oxide layer (20) is produced after the production of the dielectric layer (18) and before the patterning,
and/or **in that** the oxide layer (20) is likewise patterned before the patterning of the main layer (14).

8. Method according to Claim 7, **characterized in that** the oxide layer (20) is a layer containing silicon dioxide or a silicon dioxide layer.

9. Method according to any of the preceding claims, **characterized in that** the substrate (10, 110) is a semiconductor material, in particular silicon,
and/or **in that** the base layer is an oxide layer that has been produced on the substrate preferably by thermal oxidation, in particular a silicon dioxide layer.

10. Method according to any of the preceding claims, **characterized in that** the time for the thermal oxidation is greater than 3 seconds,
and/or **in that** the time for the thermal oxidation is 5 seconds.

11. Method according to any of the preceding claims, **characterized in that** the temperature for the thermal oxidation is approximately 1050°C.

## Revendications

1. Procédé de fabrication d'un dispositif (9, 100) à semiconducteur split-gate intégré,
dans lequel on produit une couche (14) principale sur une surface d'un substrat (10) et d'une couche (12) de base,
dans lequel on dope la couche (14) principale lors de la production ou après la production,
dans lequel on produit une couche (16) d'oxyde sur la couche (14) principale par oxydation thermique,
et dans lequel on structure la couche (14) principale,
l'oxydation thermique lors de la production de la couche (14) principale étant le premier stade opératoire ayant une température opératoire, qui est supérieure ou à peu près égale à la température opératoire lors de la production de la couche (14) principale,
et la couche (14) principale étant une couche de silicium polycristalline d'électrodes de mémoire, sur laquelle la couche (16) d'oxyde est produite,
**caractérisé en ce qu'**on effectue l'oxydation thermique dans une installation RTP pendant une durée inférieure à 35 secondes à une température de 1 000°C à 1 100°C,
**en ce qu'**on introduit, dans une cavité produite lors de la structuration, une couche (22) conductrice de l'électricité,
**en ce qu'**une partie de la couche (22) conductrice de l'électricité reste à l'intérieur de la cavité et une partie de la couche (22) conductrice de l'électrice reste à l'extérieur de la cavité, et
**en ce que** les deux parties forment la borne (22) split-gate d'un transistor (9, 100) de mémoire.

2. Procédé suivant la revendication 1, **caractérisé en ce qu'**on produit la couche (16) d'oxyde sur toute la surface mise à nue de la couche (14) principale,
et **en ce qu'**on structure la couche (16) d'oxyde, avant la structuration de la couche (14) principale.

3. Procédé suivant la revendication 1 ou 2, **caractérisé en ce que** la couche (12) de base est une couche d'oxyde produite sur une surface du substrat (10).

4. Procédé suivant l'une des revendications précédentes, **caractérisé en ce que**, lors de la structuration, on met à nu le substrat par endroit, sans attaquer le substrat soi-même,
ou **en ce que**, lors de la structuration, on met à nu la couche (12) de base par endroit, sans attaquer la couche (12) de base soi-même.

5. Procédé suivant l'une des revendications précédentes, **caractérisé en ce que**, après l'oxydation thermique et avant la structuration, on produit une couche (18) diélectrique,
et/ou **en ce qu'**on structure la couche (18) diélectrique, avant la structuration de la couche (14) principale.

6. Procédé suivant la revendication 5, **caractérisé en ce que** la couche (18) diélectrique est une couche de nitrure,
et/ou **en ce que** la couche (18) diélectrique est une couche de nitrure de silicium,
et/ou **en ce que** la couche (18) diélectrique est une couche d'oxynitrure.

7. Procédé suivant la revendication 5 ou 6, **caractérisé en ce que**, après la production de la couche (18) diélectrique et avant la structuration, on produit une couche (20) d'oxyde, et/ou **en ce qu'**on structure également la couche (20) d'oxyde avant la structuration de la couche (14) principale.

8. Procédé suivant la revendication 7, **caractérisé en ce que** la couche (20) d'oxyde est une couche contenant du dioxyde de silicium ou une couche de dioxyde de silicium.

9. Procédé suivant l'une des revendications précédentes, **caractérisé en ce que** le substrat (10, 110) est un matériau semiconducteur, notamment du silicium,
et/ou **en ce que** la couche de base est une couche d'oxyde, qui a été produite sur le substrat, de préférence par oxydation thermique, en étant notamment une couche de dioxyde de silicium.

10. Procédé suivant l'une des revendications précédentes, **caractérisé en ce que** la durée de l'oxydation thermique est plus grande que 3 secondes,
et/ou **en ce que** la durée de l'oxydation thermique est de 5 secondes.

11. Procédé suivant l'une des revendications précédentes, **caractérisé en ce que** la température pour l'oxydation thermique est d'environ 1 050°C.
